# EUROPEAN PATENT APPLICATION

(11) **EP 1 117 005 A1**
(43) Date of publication of application: **18.07.2001**
(21) Application number: 01101002.2
(22) Date of filing: 17.01.2001
(51) Int. Cl.: G03F 7/038, C08F 220/06, C08F 222/10, C08F 290/06

(54) **Polymer compound, method of producing the same, photosensitive composition, and pattern formation method**

(30) Priority: 17.01.2000 JP 2000007728; 26.12.2000 JP 2000395738
(71) Applicant: Toyo Gosei Kogyo Co., Ltd., Ichikawa-shi, Chiba 272-0012 (JP)
(72) Inventor: Utsunomiya, Shin, Photosensitive Materials Res.Lab, Inba-mura, Inba-gun, Chiba 270-1609 (JP); Yamada, Seigo, Photosensitive Materials Res.Lab, Inba-mura, Inba-gun, Chiba 270-1609 (JP)
(74) Representative: Strehl Schübel-Hopf & Partner

(57) **Abstract**

The present invention provides a cross-linkable polymer compound which can be developed with an aqueous developer and exhibits excellent patterning properties; a photosensitive composition containing the same; and a pattern formation method employing the composition. The polymer compound containing monomer units represented by formulas (I) to 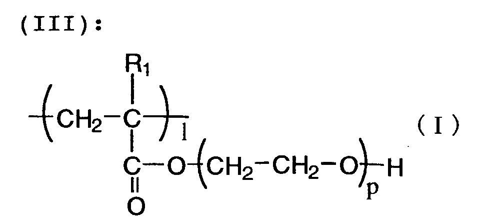 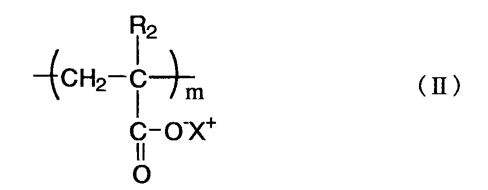 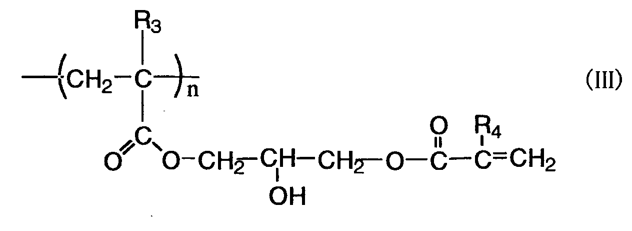 wherein each of R₁ to R₄ is hydrogen and/or a methyl group; p represents an integer between 1 to 10 inclusive; X represents hydrogen, an alkali metal, or an ammonium represented by formula (1): 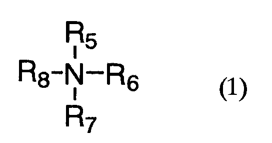 wherein each of R₅ to R₈ represents hydrogen, a C1-C3 alkyl group, or a C1-C3 alkanol group; and a plurality of Xs may be the same or different from one another, the compositional proportions of the monomer units falling within the following ranges: 2 mol% ≤ 1 ≤ 73 mol%; 8 mol% ≤ m ≤ 83 mol%; and 15 mol% ≤ n ≤ 80 mol%.

## Description

### BACKGROUND OF THE INVENTION

### Field of the Invention

The present invention relates to a polymer compound serving as a component of a negative-type photosensitive composition, and to a photosensitive composition containing the compound. In particular, the invention relates to a polymer compound which can be developed with an aqueous developer and exhibits excellent patterning properties, and to a photosensitive composition containing the compound.

### Background Art

There have been known, as photosensitive compositions contained in a photopolymerization-type resist developable with an aqueous developer, compositions comprising a carboxyl-group-containing acrylic or methacrylic copolymer to which is added an acrylate monomer or a methacrylate monomer (hereinafter acrylic acid and methacrylic acid are collectively referred to as (meth)acrylic acid, and acrylate and methacrylate are collectively referred to as (meth)acrylate). These photosensitive compositions have been developed from various aspects and employed in a variety of fields. For example, Japanese Patent Application Laid-Open (*kokai*) Nos. 9-236917 and 9-249823 disclose that such photosensitive compositions find use as photoetching resists employed in steps for producing printed wiring boards.

However, these resists, having poor solubility in water, are developed with an alkaline solution, and such alkaline developers must be handled carefully. In addition, in order to enhance hardness of cured products thereof, there must be added a (meth)acrylate monomer, which is generally a strong skin-irritant and inflammable. This also makes the handling thereof difficult, and the monomers are not preferably employed.

### SUMMARY OF THE INVENTION

The present inventors have found that a polymer compound produced by adding glycidyl (meth)acrylate in a predetermined amount to a copolymer comprising at least (meth)acrylic acid and at least one of 2-hydroxyethyl (meth)acrylate and polyoxyethylene mono(meth)acrylate can be developed with water, exhibits excellent adhesion to a substrate, and has excellent acid resistance. The present invention has been accomplished on the basis of this finding.

Accordingly, in a first aspect of the present invention, there is provided a polymer compound containing monomer units represented by formulas (I) to (III): 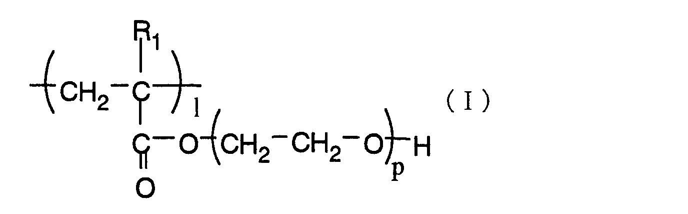 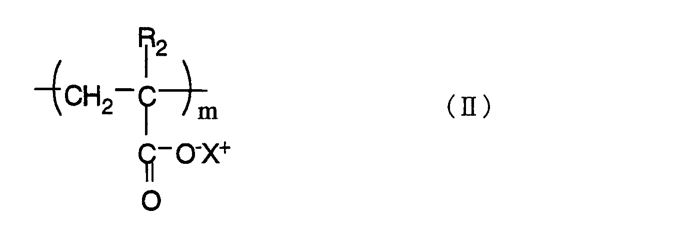 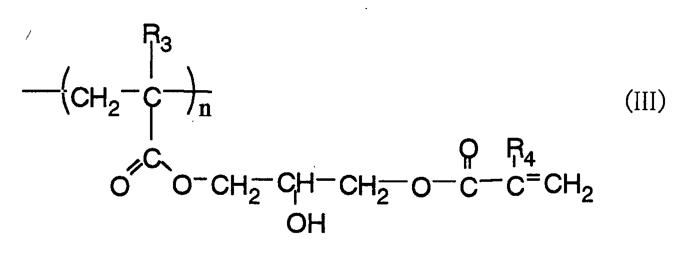 wherein each of R₁ to R₄ is hydrogen and/or a methyl group; p represents an integer between 1 to 10 inclusive; X represents hydrogen, an alkali metal, or an ammonium represented by formula (1): 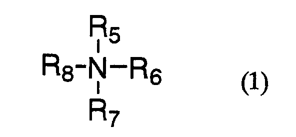 wherein each of R₅ to R₈ represents hydrogen, a C1-C3 alkyl group, or a C1-C3 alkanol group; and a plurality of Xs may be the same or different from one another,
the compositional proportions of the monomer units falling within the following ranges:
2 mol% ≤ 1 ≤ 73 mol%; 8 mol% ≤ m ≤ 83 mol%; and 15 mol% ≤ n ≤ 80 mol%.

Preferably, the polymer compound according to the first aspect of the present invention also contains a monomer unit other than monomer units represented by formula (I) to (III) in an amount of 10 mol% or less.

In a second aspect of the present invention, there is provided a method of producing a polymer compound containing monomer units represented by the aforementioned formula (I) to (III), the compositional proportions of the monomer units falling within the following ranges:
2 mol% ≤ 1 ≤ 73 mol%; 8 mol% ≤ m ≤ 83 mol%; and 15 mol% ≤ n ≤ 80 mol%, comprising adding glycidyl (meth)acrylate in a predetermined amount to a copolymer comprising at least (meth)acrylic acid and at least one of 2-hydroxyethyl (meth)acrylate and polyoxyethylene mono(meth)acrylate.

Preferably, in the method of producing a polymer compound according to the second aspect of the invention, at least one of an N-nitrosophenylhydroxylamine ammonium salt and 4-hydroxy-2,2,6,6-tetramethylpiperidin-1-oxyl is employed as a polymerization inhibitor.

In a third aspect of the present invention, there is provided a photosensitive composition containing, as a component, a polymer compound as recited in the first aspect of the invention.

Preferably, the photosensitive composition according to the third aspect of the invention contains water as a solvent.

Preferably, the photosensitive composition according to the third aspect of the invention contains a polymerizable monomer.

Preferably, the photosensitive composition according to the third aspect of the invention contains a colorant.

Preferably, the photosensitive composition according to the third aspect of the invention contains at least one of a photopolymerization initiator and a photosensitizer.

In a fourth aspect of the present invention, there is provided a pattern formation method comprising forming a coating film by use of a photosensitive composition as recited in the third aspect of the invention and developing by use of water; i.e., a neutral developer.

In view of the foregoing, an object of the present invention is to provide a polymer compound producing a photosensitive composition which is less flammable, can be handled easily, can be developed with water, and can attain high resolution without incorporating an additional monomer. Another object of the present invention is to provide a photosensitive composition containing the polymer compound. Still another object of the invention is to provide a pattern formation method.

### DETAILED DESCRIPTION OF PREFERRED EMBODIMENTS

The polymer compound of the present invention contains thermally curable monomer units (I) and (II), which undergo thermal cross-linking reaction, and photocurable monomer unit (III) in combination.

No particular limitation is imposed on the bonding manner between the monomer units so long as the polymer compound of the present invention contains the units represented by (I), (II), and (III), and the polymer compound may be any type of polymer such as a random copolymer, an alternating copolymer, a block copolymer, or a graft copolymer.

The preferred compositional proportions (the aforementioned 1, m, and n) of units (I) to (III) contained in the polymer compound of the present invention are 2 mol% ≤ 1 ≤ 73 mol%; 8 mol% ≤ m ≤ 83 mol%; and 15 mol% ≤ n ≤ 80 mol%, respectively. When the proportion "1" is considerably low, thermal curability―one characteristic of the polymer compound of the present invention―cannot be attained, whereas when the proportion "1" is excessively high, the amounts of other monomer units decrease, failing to attain sufficient photosensitivity. When the proportion "m" is considerably low, required developability and water-solubility cannot be attained, whereas when the proportion is excessively high, water resistance of cured products thereof decreases. When the proportion "n" is considerably low, required developability cannot be attained, whereas when the proportion is excessively high, the amounts of other monomer units decrease, failing to attain required developability, water-solubility, and thermal curability. The parameter "p" is generally 1 to 10. However, when "p" is in excess of 10, both resolution of the photosensitive composition containing the compound and water resistance of cured products thereof decrease.

Other than monomer units (I) to (III), the polymer compound may or may not contain another copolymerizable component. The preferred amount of the copolymerizable component is less than 10 mol% so as not to affect adhesion of the polymer compound and physical properties of the cured composition.

Examples of other copolymerizable components include unsaturated organic acids such as maleic acid and anhydrides thereof; (meth)acrylates such as methyl (meth)acrylate, ethyl (meth)acrylate, propyl (meth)acrylate, isopropyl (meth)acrylate, butyl (meth)acrylate, benzyl (meth)acrylate, and hydroxypropyl (meth)acrylate; acrylamides such as N-methylacrylamide, N-ethylacrylamide, N-isopropylacrylamide, N-methylolacrylamide, N-methylmethacrylamide, N-ethylmethacrylamide, N-isopropylmethacrylamide, N-methylolmethacrylamide, N,N-dimethylacrylamide, N,N-diethylacrylamide, N,N-dimethylmethacrylamide, and N,N-diethylmethacrylamide; styrenes such as styrene and hydroxystyrene; N-vinylpyrrolidone; N-vinylformamide; N-vinylacetamide; and N-vinylimidazole.

Preferably, the polymer compound of the present invention is synthesized through polymerization in a solvent in the presence of a polymerization initiator. Although the solvent to be employed is not particularly limited, it preferably has a composition allowing the polymer compound of the present invention to be dissolved therein.

Examples of solvents include water; ethylene glycols such as ethylene glycol, diethylene glycol, triethylene glycol, and tetraethylene glycol; glycol ethers such as ethylene glycol monomethyl ether, diethylene glycol monomethyl ether, ethylene glycol diethyl ether, and diethylene glycol dimethyl ether; glycol ether acetates such as ethylene glycol monoethyl ether acetate, diethylene glycol monoethyl ether acetate, and diethylene glycol monobutyl ether acetate; propylene glycols such as propylene glycol, dipropylene glycol, and tripropylene glycol; propylene glycol ethers such as propylene glycol monomethyl ether, propylene glycol monoethyl ether, dipropylene glycol monomethyl ether, dipropylene glycol monoethyl ether, propylene glycol dimethyl ether, dipropylene glycol dimethyl ether, propylene glycol diethyl ether, and dipropylene glycol diethyl ether; propylene glycol ether acetates such as propylene glycol monomethyl ether acetate, propylene glycol monoethyl ether acetate, dipropylene glycol monomethyl ether acetate, and dipropylene glycol monoethyl ether acetate; dimethylsulfoxide; N-methylpyrrolidone; dimethylformamide, dimethylacetamide, and mixtures thereof.

The solvent is preferably employed in an amount such that the amount of the polymer compound in the solution is controlled to 5-70 wt.%, more preferably 20-60 wt.%. When the amount is 5 wt.% or less, the polymerization rate is low, and unreacted residual monomers possibly remain, whereas when the amount is 70 wt.% or more, the viscosity of the resultant solution increases, disadvantageously causing difficult handling and reaction-rate-control of the solution.

Any known polymerization initiators, such as thermal polymerization initiators, photopolymerization initiators, and redox polymerization initiators may be used. However, radical polymerization initiators such as peroxides and azo compounds are preferred, in view of easy handling and controllability of reaction rate and molecular weight.

Examples of peroxide type polymerization initiators include methyl ethyl ketone peroxide, cyclohexanone peroxide, methylcyclohexanone peroxide, acetylacetone peroxide, methyl acetoacetate peroxide, 1,1-bis(tert-butylperoxy)-3,3,5-trimethylcyclohexane, 1,1-bis(tert-butylperoxy)cyclohexane, 1,1-bis(tert-hexylperoxy)-3,3,5-trimethylcyclohexane, 1,1-bis(tert-hexylperoxy)cyclohexane, 1,1-bis(tert-butylperoxy)cyclododecane, isobutyryl peroxide, lauroyl peroxide, succinyl peroxide, 3,5,5-trimethylhexanoyl peroxide, benzoyl peroxide, octanoyl peroxide, stearoyl peroxide, diisopropylperoxy dicarbonate, di-n-propylperoxy dicarbonate, di-2-ethylhexylperoxy dicarbonate, di-2-ethoxyethylperoxy dicarbonate, di-2-methoxybutylperoxy dicarbonate, bis(4-tert-butylcyclohexyl)peroxy dicarbonate, (α,α-bis-neodecanoylperoxy)diisopropylbenzene, cumyl peroxyneodecanoate, octyl peroxyneodecanoate, hexyl peroxyneodecanoate, tert-butyl peroxyneodecanoate, tert-hexyl peroxypivalate, tert-butyl peroxypivalate, 2,5-dimethyl-2,5-bis(2-ethylhexanoylperoxy)hexane, 1,1,3,3-tetramethylbutyl peroxy-2-ethylhexanoate, tert-hexyl peroxy-2-ethylhexanoate, tert-butyl peroxy-2-ethylhexanoate, tert-butyl peroxy-3-methylpropionate, tert-butyl peroxylaurate, tert-butyl peroxy-3,5,5-trimethylhexanoate, tert-hexylperoxyisopropyl monocarbonate, tert-butylperoxyisopropyl carbonate, 2,5-dimethyl-2,5-bis(benzoylperoxy)hexane, tert-butyl peracetate, tert-hexyl perbenzoate, and tert-butyl perbenzoate. These peroxides may be combined with a reducing agent so as to provide redox initiator systems.

Examples of azo type polymerization initiators include 1,1-azobis(cyclohexane-1-carbonitrile), 2,2'-azobis(2-methylbutyronitrile), 2,2'-azobisisobutyronitrile, 2,2'-azobis(2,4-dimethyl-valeronitrile), 2,2'-azobis(2,4-dimethyl-4-methoxyvaleronitrile), 2,2'-azobis(2-amidino-propane) hydrochloride, 2,2'-azobis[2-(5-methyl-2-imidazolin-2-yl)propane] hydrochloride, 2,2'-azobis[2-(2-imidazolin-2-yl)propane] hydrochloride, 2,2'-azobis[2-(5-methyl-2-imidazolin-2-yl)propane], 2,2'-azobis{2-methyl-N-[1,1-bis(2-hydroxymethyl)-2-hydroxyethyl]propionamide}, 2,2'-azobis[2-methyl-N-(2-hydroxyethyl)propionamide], 2,2'-azobis(2-methylpropionamide) dihydrate, 4,4'-azobis(4-cyanovaleric acid), 2,2'-azobis(2-hydroxymethylpropionitrile), 2,2'-azobis(2-methyl propionic acid) dimethyl ester (dimethyl 2,2'-azobis(2-methylpropionate)) (V-601, product of Wako Pure Chemical Industries, Ltd.), and cyano-2-propylazoformamide.

In addition to the aforementioned peroxide-type initiators and azo-type initiators, known molecular-weight-controlling agents such as a chain transfer agent, a chain terminating agent, and a polymerization accelerator may be incorporated in order to attain a molecular weight falling within a preferable range.

To the thus-synthesized polymer compound, a catalyst, a solvent, and a polymerization inhibitor for suppressing polymerization of (meth)acryloyl groups are added in accordance with needs. The mixture is heated for a predetermined time, performing addition of glycidyl (meth)acrylate.

Examples of catalysts include amines such as pyridine, quinoline, imidazole, N,N-dimethylcyclohexylamine, triethylamine, N-methylmorpholine, N-ethylmorpholine, triethylenediamine, N,N-dimethylaniline, N,N-dimethylbenzylamine, and tris(N,N-dimethylaminomethyl)phenol; quaternary ammonium compounds such as tetramethylammonium chloride, tetramethylammonium bromide, trimethylbenzylammonium chloride, and tetramethylammonium hydroxide; tributylphosphine; and triphenylphosphine.

Examples of polymerization inhibitors include hydroquinone, hydroquinone monomethyl ether, t-butylhydroquinone, t-butylcatechol, N-methyl-N-nitrosoaniline, N-nitrosophenylhydroxylamine ammonium salt (Q-1300, product of Wako Pure Chemical Industries, Ltd.), N-nitrosophenylhydroxylamine aluminum salt (Q-1301, product of Wako Pure Chemical Industries, Ltd.), 2,2,6,6-tetramethylpiperidin-1-oxyl, and 4-hydroxy-2,2,6,6-tetramethylpiperidin-1-oxyl. Of these, N-nitrosophenylhydroxylamine ammonium salt and 4-hydroxy-2,2,6,6-tetramethylpiperidin-1-oxyl are particularly preferred.

In order to enhance water-solubility and developability, the thus-synthesized polymer compound may be neutralized with an inorganic alkaline compound or an organic amine or ammonium. Examples of inorganic alkaline compounds include alkali metal hydroxides such as caustic soda. Examples of organic amines include alkylamines such as triethylamine; and alkylalkanolamines such as dimethylaminoethanol. Examples of organic ammoniums include ammonium hydroxide, methylammonium hydroxide, dimethylammonium hydroxide, trimethylammonium hydroxide, and tetramethylammonium hydroxide (TMAH).

The suitable neutralization degree varies depending on the properties of the polymer compound such as the composition, molecular weight, target water solubility, and developability. Thus, the neutralization degree may be appropriately predetermined in accordance with purposes.

The thus-synthesized polymer compound may be isolated in the form of a solid so as to effect purification, storage, changing the solvent, etc. By use of the solid form polymer compound, a photosensitive composition free of organic solvent can be provided. No particular limitation is imposed on the method of isolation, and methods such as spray drying, film drying, dropwise addition to a poor solvent, and reprecipitation may be employed.

In order to formulate a photosensitive composition by use of the thus-synthesized polymer compound, a photopolymerization initiator and/or a photosensitizer is preferably added. These compounds may be dissolved or dispersed in a solvent, followed by addition to the composition. Alternatively, these compounds may be chemically linked to the polymer compound.

No particular limitation is imposed on the employed photopolymerization initiators and photosensitizers. Examples include benzophenones such as benzophenone, 4-hydroxybenzophenone, bis-N,N-dimethylaminobenzophenone, bis-N,N-diethylaminobenzophenone, and 4-methoxy-4'-dimethylaminobenzophenone; thioxanthones such as thioxanthone, 2,4-diethylthioxanthone, isopropylthioxanthone, chlorothioxanthone, and isopropoxychlorothioxanthone; anthraquinones such as ethylanthraquinone, benzanthraquinone, aminoanthraquinone, chloroanthraquinone, anthraquinone-2-sulfonate salts, and anthraquinone-2,6-disulfonate salts; acetophenones; benzoine ethers such as benzoin methyl ether, benzoin ethyl ether, and benzoin phenyl ether; 2,4,6-trihalomethyltriazines; 1-hydroxycyclohexyl phenyl ketone; 2,4,5-triarylimidazole dimers such as 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-diphenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer, and 2-(2,4-dimethoxyphenyl)-4,5-diphenylimidazole dimer; benzyl dimethyl ketal; 2-benzyl-2-dimethylamino-1-(4-morpholinophenyl)-butan-1-one; 2-methyl-1-[4-(methylthio)phenyl]-2-morpholino-1-propanone; 2-hydroxy-2-methyl-1-phenyl-propan-1-one, 1-[4-(2-hydroxyethoxy)-phenyl]-2-hydroxy-2-methyl-1-propan-1-one; phenanthrequinone; 9,10-phenanthrequinone; benzoins such as methylbenzoin and ethylbenzoin; acridine derivatives such as 9-phenylacridine and 1,7-bis(9,9'-acridinyl)heptane; bisacylphosphine oxides; and mixtures thereof.

In addition to these photopolymerization initiators and/or photosensitizers, other additives such as an accelerator may be further added. Examples include ethyl p-dimethylaminobenzoate, isoamyl p-dimethylaminobenzoate, N,N-dimethylethanolamine, N-methyldiethanolamine, and triethanolamine.

By adding a polymerizable monomer, the sensitivity, resistance to chemicals, heat resistance, and mechanical strength of the photosensitive composition of the present invention can be enhanced. Such a polymerizable monomer may also be added so as to control the flow characteristics of the composition. The type of the monomers cannot be definitely fixed, and in accordance with use and purposes of the composition to be applied, appropriate selection of polymerizable monomers is required. Examples of monomers include polyethylene glycol di(meth)acrylate (the number of EO units: 2-14), trimethylolpropane di(meth)acrylate, trimethylolpropane tri(meth)acrylate, trimethylolpropanethoxy tri(meth)acrylate, trimethylolpropanepropoxy tri(meth)acrylate, tetramethylolmethane tri(meth)acrylate, tetramethylolmethane tetra(meth)acrylate, polypropylene glycol di(meth)acrylate (the number of PO units: 2-14), dipentaerythritol penta(meth)acrylate, dipentaerythritol hexa(meth)acrylate, bisphenol A polyoxyethylene di(meth)acrylate,bisphenol A dioxyethylene di(meth)acrylate, bisphenol A trioxyethylene di(meth)acrylate, and bisphenol A decaoxyethylene di(meth)acrylate; esters obtained from a polyvalent carboxylic acid (e.g., phthalic anhydride) and a compound having a hydroxyl group and an ethylenic unsaturated group (e.g., β-hydroxyethyl (meth)acrylate; alkyl (meth)acrylates such as methyl (meth)acrylate, ethyl (meth)acrylate, butyl (meth)acrylate, and 2-ethylhexyl (meth)acrylate; (meth)acrylic acid adducts of epoxy compounds such as ethylene glycol diglycidyl ether, diethylene glycol diglycidyl ether, triethylene glycol diglycidyl ether, tetraethylene glycol diglycidyl ether, polyethylene glycol diglycidyl ether, propylene glycol diglycidyl ether, dipropylene glycol diglycidyl ether, tripropylene glycol diglycidyl ether, tetrapropylene glycol diglycidyl ether, polypropylene glycol diglycidyl ether, sorbitol triglycidyl ether, and glycerin triglycidyl ether, unsaturated organic acids such as maleic acid and anhydrides thereof; (meth)acrylates such as methyl (meth)acrylate, ethyl (meth)acrylate, propyl (meth)acrylate, isopropyl (meth)acrylate, butyl (meth)acrylate, benzyl (meth)acrylate, and hydroxypropyl (meth)acrylate; acrylamides such as N-methylacrylamide, N-ethylacrylamide, N-isopropylacrylamide, N-methylolacrylamide, N-methylmethacrylamide, N-ethylmethacrylamide, N-isopropylmethacrylamide, N-methylolmethacrylamide, N,N-dimethylacrylamide, N,N-diethylacrylamide, N,N-dimethylmethacrylamide, and N,N-diethylmethacrylamide; styrenes such as styrene and hydroxystyrene; N-vinylpyrrolidone; N-vinylformamide; N-vinylacetamide; N-vinylimidazole; and mixtures thereof.

By adding a colorant, halation of the photosensitive composition caused by a substrate surface and dispersible additives can be reduced, to thereby enhance resolution. The type of colorants to be added cannot be definitely fixed, and appropriate selection of the colorants is required, in accordance with the material of a substrate onto which a pattern is formed and the photopolymerization initiator to be applied. Examples of colorants include dyes formed of species such as phthalocyanine, anthraquinone, azo, indigo, coumarine, and triphenylmethane; pigments formed of species such as phthalocyanine, anthraquinone, azo, quinacridone, coumarine, and triphenylmethane; and mixtures thereof. These colorants may also be added so as to facilitate visual inspection of products.

The photosensitive composition of the present invention may be formed into a solution or paste. A solvent may be added so as to form a solution or paste. Such a solvent is not particularly limited, and examples include water; ethylene glycols such as ethylene glycol, diethylene glycol, triethylene glycol, and tetraethylene glycol; glycol ethers such as ethylene glycol monomethyl ether, diethylene glycol monomethyl ether, ethylene glycol diethyl ether, and diethylene glycol dimethyl ether; glycol ether acetates such as ethylene glycol monoethyl ether acetate, diethylene glycol monoethyl ether acetate, and diethylene glycol monobutyl ether acetate; propylene glycols such as propylene glycol, dipropylene glycol, and tripropylene glycol; propylene glycol ethers such as propylene glycol monomethyl ether, propylene glycol monoethyl ether, dipropylene glycol monomethyl ether, dipropylene glycol monoethyl ether, propylene glycol dimethyl ether, dipropylene glycol dimethyl ether, propylene glycol diethyl ether, and dipropylene glycol diethyl ether; propylene glycol ether acetates such as propylene glycol monomethyl ether acetate, propylene glycol monoethyl ether acetate, dipropylene glycol monomethyl ether acetate, and dipropylene glycol monoethyl ether acetate; dimethylsulfoxide; N-methylpyrrolidone; dimethylformamide, dimethylacetamide, and mixtures thereof. The photosensitive composition preferably contains water, in consideration of problems such as safety of operation circumstances and flammability.

Into the photosensitive composition of the present invention, other known components such as a polymerization inhibitor, a plasticizer, a defoaming agent, and a coupling agent may be incorporated in accordance with needs.

The aforementioned compositional proportions in the photosensitive composition of the present invention cannot be definitely fixed, and appropriate values vary depending on conditions such as the composition of the polymer compound, type of monomers, and production steps such as method of application and light-exposure of the composition. However, the compositional proportions can be predetermined in accordance with purposes. For example, the following compositional range is preferred:

| | |
|---|---|
| Polymer compound: | 1-95 wt.% |
| Photopolymerization initiator and photosensitizer: | 0.02-30 wt.% |
| Water: | 2-96 wt.% |
| Polymerizable monomer(s): | 0-60 wt.% |
| Colorant(s): | 0-50 wt.%. |

The photosensitive composition of the present invention is applied as a solution or a paste. No particular limitation is imposed on the method for applying the composition, and a variety of coating methods such as screen printing, curtain coating, blade coating, spin coating, spray coating, dip coating, and slit coating may be employed.

The thus-applied solution or paste is dried and then exposed to UV rays or an electron beam through a specific mask.

The exposed coating is developed in a wet manner, to thereby form a pattern.

Any developing method may be employed, such as development by means of a spray, paddles, or dipping. Particularly, development by means of a spray is preferred, in view of generation of a small amount of developer waste. Ultrasound may be applied if required.

Although the developer is preferably water; i.e., a neutral developer, a weakly acidic or alkaline developer may also be employed. Additives such as an organic solvent, a surfactant, and a defoaming agent may be added so as to enhance performance of the developer.

### EXAMPLES

The present invention will next be described in detail by way of examples, which should not be construed as limiting the invention thereto, as the photosensitive compositions comprising the polymer compound of the invention come in a variety of types and have various purposes of use.

### Synthesis Example 1

2-Hydroxyethyl acrylate (43.5 g), methacrylic acid (130.5 g), and dimethyl 2,2'-azobis(2-methylpropionate) (V-601, product of Wako Pure Chemical Industries, Ltd.) (6.8 g) were dissolved in propylene glycol (87.0 g) to form a solution. The solution was added dropwise to propylene glycol (457.4 g) under nitrogen flow over two hours, while the propylene glycol was maintained at 80°C. The resultant mixture was aged for four hours under the same conditions. Subsequently, the temperature of the mixture was elevated to 100°C for reaction, and the heated mixture was aged for two hours, forming a transparent viscous polymer solution. The polymer solution was cooled again to 80°C. To the cooled mixture, pyridine (13.0 g) and an N-nitrosophenylhydroxylamine ammonium salt (Q-1300, product of Wako Pure Chemical Industries, Ltd.) (0.6 g) dissolved in propylene glycol (32.0 g) were individually added. Then, glycidyl methacrylate (116.0 g) was added dropwise to the resultant mixture over 30 minutes, and the reaction mixture was maintained at 80°C for a further six hours, to thereby obtain a pale-red viscous polymer solution (A).

Unreacted monomers contained in the thus-obtained polymer solution (A) were quantitatively determined through high-performance liquid chromatography to thereby calculate the balance (mol%) of monomers (I) to (III) in the polymer, and the results revealed that 1, m, and n were 13.7 mol%, 56.5 mol%, and 29.8 mol%, respectively. The polymer solution had an acid value of 100 mg-KOH/g and an unsaturation equivalent of 1.4 meq/g.

### Synthesis Example 2

The polymer solution (A) (100 g) which had been produced in Synthesis Example 1 was added dropwise to ethyl acetate (1000 ml) placed in a vessel equipped with an agitator, to effect dispersion for one hour. The resultant matter was separated through filtration and dried, to thereby obtain a white powder (B).

### Synthesis Example 3

2-Hydroxyethyl acrylate (60.0 g), acrylic acid (180.0 g), and dimethyl 2,2'-azobis(2-methylpropionate) (V-601, product of Wako Pure Chemical Industries, Ltd.) (2.0 g) were dissolved in propylene glycol (63.0 g), to form a solution. The solution was added dropwise to propylene glycol (356.9 g) under nitrogen flow over two hours, while the propylene glycol was maintained at 80°C. The resultant mixture was aged for four hours under the same conditions. Subsequently, the temperature of the mixture was elevated to 100°C for reaction, and the heated mixture was aged for two hours, forming a transparent viscous polymer solution. The polymer solution was cooled again to 80°C. To the cooled mixture, pyridine (17.8 g) and an N-nitrosophenylhydroxylamine ammonium salt (Q-1300, product of Wako Pure Chemical Industries, Ltd.) (0.4 g) dissolved in propylene glycol (32.0 g) were individually added. Then, glycidyl methacrylate (160.0 g) was added dropwise to the resultant mixture over 30 minutes, and the reaction mixture was maintained at 80°C for a further six hours, to thereby obtain a pale-red viscous polymer solution (C).

Unreacted monomers contained in the thus-obtained polymer solution (C) were quantitatively determined through high-performance liquid chromatography to thereby calculate the balance (mol%) of monomers (I) to (III) in the polymer, and the results revealed that 1, m, and n were 12.4 mol%, 61.3 mol%, and 26.3 mol%, respectively. The polymer solution had an acid value of 48.2 mg-KOH/g and an unsaturation equivalent of 0.96 meq/g.

### Comparative Synthesis Example 1

A solution containing methyl methacrylate (80.0 g), isobutyl methacrylate (5.0 g), acrylic acid (15.0 g), and dimethyl 2,2'-azobis(2-methylpropionate) (V-601, product of Wako Pure Chemical Industries, Ltd.) (0.7 g) was added dropwise to the diethylene glycol mono buthyl ether (65.0 g) under nitrogen flow over five hours, while the diethylene glycol mono buthyl ether was maintained at 80°C. The resultant mixture was aged for one hour under the same conditions. Subsequently, the temperature of the mixture was elevated to 100°C for reaction, and the heated mixture was aged for two hours, forming a transparent viscous polymer solution. The polymer solution was cooled again to 80°C. To the cooled mixture, pyridine (1.5 g) and hydroquinone (0.2 g) serving as a polymerization inhibitor were individually added. Then, glycidyl methacrylate (15.0 g) was added dropwise to the resultant mixture over 30 minutes, and the reaction mixture was maintained at 80°C for a further six hours, to thereby obtain a pale-red viscous polymer solution (D).

Unreacted monomers contained in the thus-obtained polymer solution (D) were quantitatively determined through high-performance liquid chromatography to thereby calculate the balance (mol%) of monomers (I) to (III) in the polymer, and the results revealed that 1, m, and n were 0 mol%, 17.7 mol%, and 9.2 mol%, respectively. The polymer solution had an acid value of 34.0 mg-KOH/g and an unsaturation equivalent of 0.65 meq/g.

### Example 1

To the polymer solution (A) (100 g) which had been obtained in Synthesis Example 1, a 10% aqueous solution (2.7 g) of NaOH serving as an alkali agent for neutralization; 1-[4-(2-hydroxyethoxy)-phenyl]-2-hydroxy-2-methyl-1-propan-1-one (Irgacure 2959, product of Ciba Specialty Chemicals) (1.8 g) serving as a photopolymerization initiator; and ion-exchange water (65 g) were added, to thereby prepare a photosensitive composition.

The thus-prepared photosensitive composition was applied to a metal substrate by means of a spin-coater and dried in a clean oven at 80°C for 20 minutes, followed by cooling to room temperature. The coating was exposed to ultraviolet light from an ultra-high-pressure mercury lamp having an illuminance of 2.5 mW/cm² for a dose of 1350 mJ/cm², through a mask having a predetermined pattern. Subsequently, the photocured polymer was spray-developed with ion-exchange water for 30 seconds, to thereby obtain an objective pattern. The pattern had a film thickness of 5 µm and a resolution of 10 µm, and the sensitivity of the composition as evaluated on the basis of the UGRA step tablet was 5.

The photosensitive composition was stored at 40°C, and variation in patterning characteristics were evaluated. The results indicated that no variation in patterning characteristics were observed even after the composition had been stored for two weeks. The photosensitive composition was subjected to flash point measurement in a Cleveland-open manner, and the results indicated that no flash point was identified.

### Example 2

To the white powder (B) (35 g) which had been obtained in Synthesis Example 2, a 10% aqueous solution (2.7 g) of NaOH serving as an alkali agent for neutralization; 1-[4-(2-hydroxyethoxy)-phenyl]-2-hydroxy-2-methyl-1-propan-1-one (Irgacure 2959, product of Ciba Specialty Chemicals) (1.8 g) serving as a photopolymerization initiator; and ion-exchange water (130 g) were added. The powder was sufficiently dissolved into the solution, to thereby prepare a photosensitive composition.

The thus-prepared photosensitive composition was applied to a metal substrate by means of a spin-coater and dried in a clean oven at 80°C for 20 minutes, followed by cooling to room temperature. The coating was exposed to ultraviolet light from an ultra-high-pressure mercury lamp having an illuminance of 2.5 mW/cm² for a dose of 1350 mJ/cm², through a mask having a predetermined pattern. Subsequently, the photocured polymer was spray-developed with ion-exchange water for 30 seconds, to thereby obtain an objective pattern. The pattern had a film thickness of 5 µm and a resolution of 10 µm, and the sensitivity of the composition as evaluated on the basis of the UGRA step tablet was 5.

The photosensitive composition was stored at 40°C, and variation in patterning characteristics were evaluated. The results indicated that no variation in patterning characteristics were observed even after the composition had been stored for two weeks. The photosensitive composition was subjected to flash point measurement in a Cleveland-open manner, and the results indicated that no flash point was identified.

### Example 3

To the polymer solution (C) (100 g) which had been obtained in Synthesis Example 3, a 10% aqueous solution (6.8 g) of NaOH serving as an alkali agent for neutralization; 1-[4-(2-hydroxyethoxy)-phenyl]-2-hydroxy-2-methyl-1-propan-1-one (Irgacure 2959, product of Ciba Specialty Chemicals) (2.5 g) serving as a photopolymerization initiator; and ion-exchange water (50 g) were added, to thereby prepare a photosensitive composition.

The thus-prepared photosensitive composition was applied to a metal substrate by means of a spin-coater and dried in a clean oven at 80°C for 20 minutes, followed by cooling to room temperature. The coating was exposed to ultraviolet light from an ultra-high-pressure mercury lamp having an illuminance of 2.5 mW/cm² for a dose of 1350 mJ/cm², through a mask having a predetermined pattern. Subsequently, the photocured polymer was spray-developed with ion-exchange water for 30 seconds, to thereby obtain an objective pattern. The pattern had a film thickness of 5 µm and a resolution of 15 µm, and the sensitivity of the composition as evaluated on the basis of the UGRA step tablet was 7.

The photosensitive composition was stored at 40°C, and variation in patterning characteristics were evaluated. The results indicated that no variation in patterning characteristics were observed even after the composition had been stored for two weeks. The photosensitive composition was subjected to flash point measurement in a Cleveland-open manner, and the results indicated that no flash point was identified.

### Example 4

To the polymer solution (A) (100 g) which had been obtained in Synthesis Example 1, a 10% aqueous solution (2.7 g) of NaOH serving as an alkali agent for neutralization; 1-[4-(2-hydroxyethoxy)-phenyl]-2-hydroxy-2-methyl-1-propan-1-one (Irgacure 2959, product of Ciba Specialty Chemicals) (1.8 g) serving as a photopolymerization initiator; polyethylene glycol dimethacrylate (NK-9G, product of Shin-Nakamura Chemical Co., Ltd.) (4.0 g) serving as a polymerizable monomer; Brilliant Green (1.0 g) serving as an aqueous dye; and ion-exchange water (65 g) were added, to thereby prepare a photosensitive composition.

The thus-prepared photosensitive composition was applied to a metal substrate by means of a spin-coater and dried in a clean oven at 80°C for 20 minutes, followed by cooling to room temperature. The coating was exposed to ultraviolet light from an ultra-high-pressure mercury lamp having an illuminance of 2.5 mW/cm² for a dose of 1350 mJ/cm², through a mask having a predetermined pattern. Subsequently, the photocured polymer was spray-developed with ion-exchange water for 30 seconds, to thereby obtain an objective pattern. The pattern had a film thickness of 5 µm and a resolution of 8 µm, and the sensitivity of the composition as evaluated on the basis of the UGRA step tablet was 6.

### Comparative Example 1

To the polymer solution (D) (60 g) which had been obtained in Comparative Synthesis Example 1, pentaerythritol triacrylate (15 g), dimethylethanolamine (3.0 g) serving as an alkali agent for neutralization; 2-methyl-1-[4-(methylthio)phenyl]-2-morpholino-1-propanone (Irgacure 907, product of Ciba Specialty Chemicals) (2 g) serving as a photopolymerization initiator; and ion-exchange water (48 g) were added, to thereby prepare a photosensitive composition.

The thus-prepared photosensitive composition was applied to a metal substrate by means of a spin-coater and dried in a clean oven at 80°C for 20 minutes, followed by cooling to room temperature. The coating was exposed to ultraviolet light from an ultra-high-pressure mercury lamp having an illuminance of 2.5 mW/cm² for a dose of 1000 mJ/cm², through a mask having a predetermined pattern. Subsequently, the photocured polymer was spray-developed with ion-exchange water for 30 seconds. However, an objective pattern could not be obtained.

The photosensitive composition was stored at 40°C for two weeks, and component separation was identified.

As described hereinabove, the polymer compound of the present invention is produced by adding glycidyl (meth)acrylate in a predetermined amount to a copolymer comprising at least (meth)acrylic acid and at least one of 2-hydroxyethyl methacrylate and polyoxyethylene mono(meth)acrylate. Thus, the polymer compound developable with water; exhibits excellent adhesion to a glass or metal substrate; and has excellent acid resistance. The polymer compound is remarkably useful for producing a photosensitive composition.

## Claims

1. A polymer compound containing monomer units represented by formulas (I) to (III): 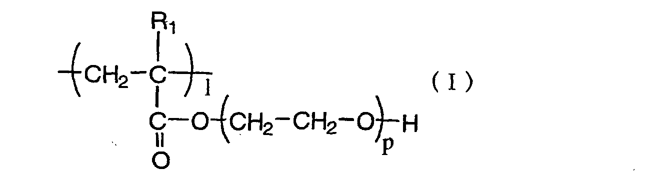 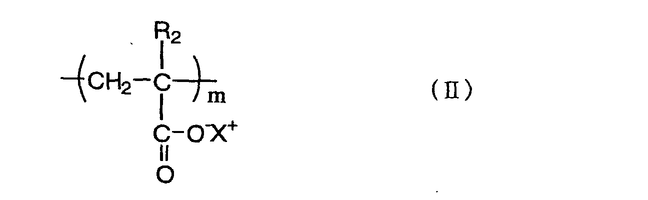 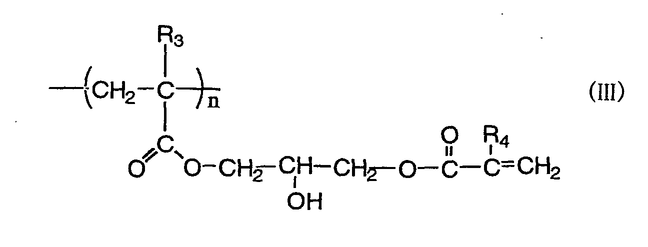 wherein each of R₁ to R₄ is hydrogen and/or a methyl group; p represents an integer from 1 to 10; X represents hydrogen, an alkali metal, or an ammonium represented by formula (1): 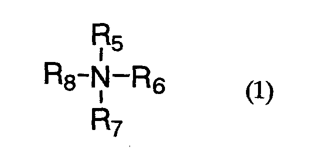 wherein each of R₅ to R₈ represents hydrogen, a C1-C3 alkyl group, or a C1-C3 alkanol group; and the Xs may be the same or different from one another,
characterized in that the compositional proportions of the monomer units fall within the following ranges: 2 mol% ≤ 1 ≤ 73 mol%; 8 mol% ≤ m ≤ 83 mol%; and 15 mol% ≤ n ≤ 80 mol%.

2. A polymer compound according to claim 1 also containing a monomer unit other than monomer units represented by formula (I) to (III) in an amount of 10 mol% or less.

3. A method of producing a polymer compound according to claim 1,
characterized by comprising adding glycidyl (meth)acrylate in a predetermined amount to a copolymer comprising at least (meth)acrylic acid and at least one of 2-hydroxyethyl (meth)acrylate and polyoxyethylene mono(meth)acrylate.

4. A method of producing a polymer compound according to claim 3, wherein at least one of an N-nitrosophenylhydroxylamine ammonium salt and 4-hydroxy-2,2,6,6-tetramethylpiperidin-1-oxyl is employed as a polymerization inhibitor.

5. A photosensitive composition characterized by containing, as a component, a polymer compound as recited in claim 1 or 2.

6. A photosensitive composition according to claim 5, which contains water as a solvent.

7. A photosensitive composition according to claim 5 or 6, which contains a polymerizable monomer.

8. A photosensitive composition according to any one of claims 5 to 7, which contains a colorant.

9. A photosensitive composition according to any one of claims 5 to 8, which contains at least one of a photopolymerization initiator and a photosensitizer.

10. A pattern formation method characterized by comprising forming a coating film by use of a photosensitive composition as recited in any one of claims 5 to 9 and developing by use of water; i.e., a neutral developer.
